# EUROPEAN PATENT APPLICATION

(11) **EP 2 624 676 A1**
(43) Date of publication of application: **07.08.2013**
(21) Application number: 11828526.1
(22) Date of filing: 16.05.2011
(51) Int. Cl.: H05K 9/00

(54) **ELECTROMAGNETIC WAVE SHIELDING SHEET FOR USE IN WIRELESS POWER TRANSMISSION**

(30) Priority: 30.09.2010 JP 2010221610
(71) Applicant: Nitto Denko Corporation, Ibaraki-shi Osaka 567-8680 (JP)
(72) Inventor: SUZUKI, Hidenori, Ibaraki-shi Osaka 567-8680 (JP); WANO, Takashi, Ibaraki-shi Osaka 567-8680 (JP); TADA, Masataka, Ibaraki-shi Osaka 567-8680 (JP); FUKUDA, Yuuki, Ibaraki-shi Osaka 567-8680 (JP)
(74) Representative: Müller-Boré & Partner Patentanwälte
(86) International application number: PCT/JP2011/061173
(87) International publication number: WO 2012/042964

(57) **Abstract**

Disclosed is an electromagnetic wave shielding sheet for use in wireless power transmission which suppresses electromagnetic wave leakage in a broad range and which is easily adaptable to various types of wireless power transmitters. The disclosed electromagnetic wave shielding sheet is used in a wireless transmitter (2) and has a multilayer structure (10) including at least one metal layer (11) and at least one magnetic material layer (12).

## Description

### Technical Field

The present invention relates to an electromagnetic wave shielding sheet for wireless power transmission.

### Background Art

In recent years, wireless power transmission not requiring a power cable or an power transmitting cable has been attracting attention as an power transmitting method adopted in power transmitters used for charging electric vehicles or the like. Examples of known technology of such as contactless wireless power transmission are an electromagnetic induction method, a magnetic resonance method, and an electric field coupling method.

Power transmission by the electromagnetic induction method is allows a wide range of applications from devices such as portable devices requiring a relatively small power to devices such as electric vehicles and transportation machinery requiring power charging of as large as several kW. The magnetic resonance method allows power transmission of a longer distance from a power transmitter to a power receiver, as compared with the electromagnetic inductance. This method therefore is expected to be used for a higher positional freedom. Further, with the electric field coupling method, power transmission is possible as long as the power receiver is placed on the surface of the power transmitter. This method therefore is expected to improve the two dimensional positional freedom.

For example, patent documents 1 and 2 describe a technology to improve the power transmission efficiency in these wireless power transmitting methods. Patent document 1 describes a structure in which a magnetic sheet is used at the back of coils used for power transmission and reception, for a purpose of improving the inductance between the coils, thus reducing a leakage of the magnetic flux to the outside. Further, the document also describes a method for absorbing the magnetic flux leaked from the periphery of the magnetic sheet, or the magnetic flux not captured by the magnetic sheet, by setting a magnetic shielding sheet on the back surface of the magnetic sheet. Further, Patent document 2 discloses a structure of a wireless power supply module intended for use for devices requiring a large amount of power such as electric vehicles. The structure has coils arranged on a core in the form of a flat plate, for the purpose of improving the power supply efficiency.

### Citation List

### Patent Literature

[Patent document 1] Japanese Unexamined Patent Publication No. 206234/2008 (Tokukai 2008-206234)
[Patent document 2] Japanese Unexamined Patent Publication No. 87733/2008 (Tokukaihei 2008-87733) Summary of Invention

### Technical Problem

The wireless power transmitters involve coupling, resonance, or the like of electric magnetic fields. These electromagnetic fields generated between coils leak outside at the time of wireless power transmission. The devices therefore serve as a source of noise negatively affecting peripheral circuits or cause abnormal heat generation of secondary batteries such as lithium-ion batteries. Further, a wireless power transmitter transmitting as large as several kW raises not only the concern about the negative effects caused by the electromagnetic fields and/or the heat generation, but also the concern about the negative effects of the electromagnetic fields to the human bodies nearby. In this regard, for example, there is a problem that the exposure levels may exceed the levels set by ICNIRP (International Commission on Non-Ionizing Radiation Protection) in "GUIDELINES FOR LIMITING EXPOSURE TO TIME-VARYING ELECTRIC, MAGNETIC, AND ELECTROMAGNETIC FIELDS,1998".

The structures of Patent documents 1 and 2 however are to be built in the wireless power transmitter. Therefore, these structures are not easily applicable to various wireless power transmitters with different shapes and different powers to be transmitted.

The present invention is made in view of the above problems, and it is an object of the present invention to provide an electromagnetic wave shielding sheet for wireless power transmission which is easily applicable to various wireless power transmitters, while suppressing leakage of electromagnetic fields at the time of wireless power transmission in a broad range.

### Technical Solution

The present invention is an electromagnetic wave shielding sheet for use in a wireless power transmitter, comprising a multilayer structure, wherein the multilayer structure comprises at least one metal layer; and at least one magnetic material layer.

In the above structure, the electromagnetic wave shielding sheet for a wireless power transmission has a multilayer structure, and has at least one metal layer and at least one magnetic material layer. In general, in an area of magnetic field intensities up to a frequency of approximately 100 MHz, non-magnetic metal has a physical property such that its magnetic shielding effect increases with an increase in the magnetic field intensity, magnetic materials have a physical property such that their magnetic shielding effect decreases with an increase in the magnetic field intensity. As such, a low frequency area of the leakage of the electromagnetic field from the wireless power transmitter is shielded mainly by the metal layer, while a high frequency area of the leakage is shielded mainly by the magnetic material layer. As the result, it is possible to maintain stable shielding effect against magnetic field intensities of a predetermined frequency range. Further, the shielding sheet formed in the form of sheet allows application of various wireless power transmitters.

Further, the electromagnetic wave shielding sheet of the present invention may be adapted so that the multilayer structure has a first adhesive layer on at least one outermost layer. With the structure, the electromagnetic wave shielding sheet can be pasted on to a wireless power transmitter, and the range of applications of the electromagnetic wave shielding sheet can be broadened.

The electromagnetic wave shielding sheet of the present invention may be adapted so that the first adhesive layer has conductivity in a thickness direction. With the above structure, it is possible to improve the conductivity from an object to which the electromagnetic wave shielding sheet is applied to the electromagnetic wave shielding sheet. This way, even if the leakage of electromagnetic waves heats the object, the heat is dissipated to the electromagnetic wave shielding sheet, thus preventing abnormal heating of the object.

The electromagnetic wave shielding sheet of the present invention may be adapted so that the metal layer is made of metal foil, and the magnetic material layer is formed in the form of sheet. The structure realizes a thin the electromagnetic wave shielding sheet, and facilitates application of the electromagnetic sheet to various types of wireless power transmitters.

The electromagnetic wave shielding sheet of the present invention may be adapted so that the multilayer structure has a second adhesive layer having conductivity in a thickness direction, which combines the metal layer with the magnetic material layer. The structure enables the metal layer and the magnetic material layer to be reliably combined with each other.

The electromagnetic wave shielding sheet of the present invention may be adapted so that the multilayer structure has metal foil as the metal layer on one outermost layer, and the first adhesive layer on another outermost layer; a through hole which is press opened from the metal foil towards the first adhesive layer, whose inner surface is the metal foil; and an exposed part where the metal foil is exposed on the other outermost layer. The structure realizes reliable conductivity between the electromagnetic wave shielding sheet and the object to which the electromagnetic wave shielding sheet is applied. Therefore it is possible to prevent abnormal heating of the object. Further, forming the metal layer by the metal foil makes the electromagnetic wave shielding sheet thin, and facilitates application of the electromagnetic sheet to various types of wireless power transmitters.

The electromagnetic wave shielding sheet of the present invention may be adapted so that the multilayer structure has the first adhesive layer on one outermost layer; and a second adhesive layer having at least one of an insulating function, a damage protecting function, and a design function, on another outermost layer. With the above structure, the electromagnetic wave shielding sheet suppressing the leakage of the electromagnetic waves can be diversified by further providing an insulative function, damage protective function, and/or a design function.

### Advantageous Effects

The present invention suppresses the leakage of electromagnetic waves in a broad range during wireless power transmission, and facilitates applications to various types of wireless power transmitters.

### Brief Description of Drawings

[Fig. 1] FIG. 1 is an explanatory diagram of a multilayer structure of an electromagnetic wave shielding sheet.
[Fig. 2(a)] FIG. 2(a) is an explanatory diagram of a method for manufacturing a metal layer and a first adhesive layer.
[Fig. 2(b)] FIG. 2(b) is an explanatory diagram of a method for manufacturing a metal layer and a first adhesive layer.
[Fig. 3] FIG. 3 is an explanatory diagram of a multilayer structure of the electromagnetic wave shielding sheet.

### Description of Embodiments

An electromagnetic wave shielding sheet related to the present invention is used for wireless power transmitters for contactless power supply. The electromagnetic wave shielding sheet may be installed inside a power transmitter or the outside of the casing of the same. Further, the sheet may be installed in a suitable part of machinery (automobile or the like) in which the power transmitter is mounted. Exemplary applications of the electromagnetic wave shielding sheet includes: personal computers, televisions, vacuum cleaners, audio devices, machine tools, medical devices, transportation machinery, street cars, buses, electric vehicles, structures such as desks and walls capable of supplying power, industrial robots, or the like; however the application is not limited to these.
The following describes a preferable embodiment of the present invention, with reference to attached drawings.

### (Electromagnetic wave shielding sheet 1)

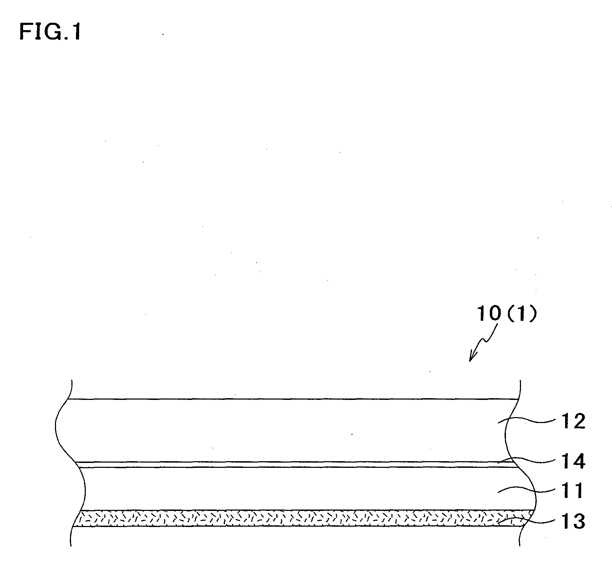

Fig. 1 is an explanatory diagram showing a multilayer structure 10 of an electromagnetic wave shielding sheet 1 related to the present embodiment. As shown in Fig. 1, the electromagnetic wave shielding sheet 1 has a multilayer structure 10. The multilayer structure 10 has a metal layer 11, and a magnetic material layer 12.

The metal layer 11 has a physical property such that its magnetic shielding effect increases with an increase in the magnetic field intensities of a predetermined frequency range. The magnetic material layer 12 also has a physical property such that its magnetic shielding effect increases with a decrease in the magnetic field intensities of the predetermined frequency range. Thus, of the electromagnetic field leaking from the wireless power transmitter 2, low frequencies are shielded by the metal layer 11, while high frequencies are shielded by the magnetic material layer 12. This enables stable shielding effect against magnetic field intensities of a predetermined frequency range.

Note that the number of metal layer 11 is not limited to one, and there may be two or more metal layers 11. Further, the number of magnetic material layer 12 is not limited to one, and there may be two or more magnetic material layers 12. In cases where the number of metal layers 11 and that of the magnetic material layers 12 are more than one, how these layers are stacked is not particularly limited; for example, the metal layers 11 and the magnetic layers 12 may be alternated one layer after another, or a stack of metal layers 11 and a stack of magnetic material layers 12 may be stacked on one another.

Specifically, the multilayer structure 10 of the electromagnetic wave shielding sheet 1 includes sequentially a magnetic material layer 12, a second adhesive layer 14 combining the magnetic material layer 12 with the metal layer 11, a metal layer 11, and a first adhesive layer 13. In other words, the outermost layers of the electromagnetic wave shielding sheet 1 are the magnetic material layer 12 and the first adhesive layer 13. The following describes each of these layers.

### (Metal Layer 11)

The metal layer 11 of the present embodiment is aluminum foil. The metal layer in the form of foil facilitates deformation of the electromagnetic wave shielding sheet 1 and application of the electromagnetic wave shielding sheet to various wireless transmission apparatus having different shapes. Note that the thickness of the metal layer 11 is not particularly limited. However, in terms of followability to the shape of the wireless transmission apparatus and workability of the electromagnetic wave shielding sheet 1, the thickness is preferably not more than 10 mm.

As hereinbelow described, aluminum foil has physical property such that its magnetic shielding effect increases with an increase in the magnetic field intensity at least in a frequency range of several hundred 100 KHz to 100 MHz. The material of the metal layer 11 is not particularly limited. For example, the metal layer 11 may be metal foil made of copper, silver, nickel, tin, iron, stainless steel, or the like. Further, for example, it is possible to adopt a plastic film on which any of the above metal is vapor-deposited, a fabric made of fibers of any of the above metal, or a fabric to which any of the above metal is plated or vapor-deposited. Further, for example, it is possible to adopt metal foil made of any of the above metals having been subjected to various surface treatments such as gold plating, silver plating, tin plating, or the like. The metal layer also may be a combination of the above materials. It should be however noticed that the material of the metal layer is preferably non-magnetic metal such as aluminum, copper, stainless steel, or the like.

### (Magnetic Material Layer 12)

The magnetic material layer 12 of the present embodiment is FINEMET (^{®}) which is a nano- crystal soft magnetic material produced by Hitachi Metals, Ltd. As hereinbelow described, FINEMET (^{®}) has physical property such that its magnetic shielding effect increases with a decrease in the magnetic field intensity at least in a frequency range of 100 KHz to 100 MHz.

The material of the magnetic material layer 12 is not particularly limited, and any known magnetic material is adoptable. For example, the magnetic material layer 12 may be made of soft ferrite, silicon steel plate, permalloy, an amorphous metal magnetic material, or a nano-crystal metal magnetic material. Further, for example, it is possible to adopt a complex magnetic sheet complexified by dispersing the powder of any of the above materials in a bonding material such as resin. It is possible to adopt a sheet in which a magnetic substance is not dispersed in a resin; e.g. a thermally compressed sheet made of an amorphous metal magnetic ribbon or a nano-crystal metal magnetic ribbon sandwiched by polyester films.

In cases of adopting a complex magnetic sheet complexified by dispersing magnetic powder in a bonding material such as resin, the powder is preferably flaky-shaped powder so as to suppressing the demagnetizing field of the magnetic powder thus facilitating a high magnetic permeability as the complex magnetic sheet. However, pulverized powder and spherical powder, or the like are also adoptable.

In cases of using various sheets as described above, it is preferable to use a ribbon such as a thermally compressed sheet which sis made by sandwiching an amorphous metal magnetic ribbon or a nano-crystal metal magnetic ribbon between polyester films. These ribbon sheets have high magnetic permeabilities and high saturated magnetic flux densities, and exerts high shielding effects not only in the frequency band used in power transmission involving electromagnetic inductance, but also in the frequency band used in power transmission involving magnetic resonance. Examples of products adoptable as these sheets include "magnetic shielding parts high magnetic permeability type (SS) produced by Toshiba Materials Co., LTD., or "FINEMET (^{®})" produced by Hitachi Metals, Ltd. , which is used in the present embodiment. In short, any material can be used as the magnetic material layer as long as the material has characteristics that are equivalent to the above-described physical property of the magnetic sheet.

### (First Adhesive Layer 13)

The first adhesive layer 13 of the present embodiment is a conductive adhesive agent whose components include a base polymer, a tackifying resin, and conductive fillers (conductive particles). Note that the base polymer and the conductive fillers are essential components, and the tackifying resin and the cross-linking agent may contain an additive as needed.

The tackifying resin, though not particularly limited, is preferably adhesive as well as conductive; e.g., a conductive organic resin composition whose polymer component such as an epoxy-based resin, a thermoplastic elastomer, silicone rubber, acrylic polymer, or the like which contains conductive fillers. It is possible to adopt the identical resin, or adopt different resins for different parts.

For the conductive organic resin composition, a silane coupling agent or a dispersant may be used to improve the adhesive property, the sustaining power, and the affinity between the conductive filler particles and the base polymer. The silane coupling agent and the dispersant may be any given known material without particular limitation. The silane coupling agent and the dispersant may be used singly or in combination by mixing two or more different types.

Examples of the conductive fillers include: a metal such as nickel, iron, chrome, cobalt, aluminum, antimony, molybdenum, copper, silver, platinum, gold; an alloy or an oxide of these metals; a filler material made of carbon such as carbon black; or a filler material made by a polymer beads or resin coated with these materials. Particularly preferred is a metal filler and/or metal-coated filler. The above conductive fillers may be used singly or in combination.

The shape of each conductive filler is not particularly limited, and the material may be in the form of bulk or layers, or have a needle-like shape or a plate-like shape. In cases of adopting the conductive fillers in the form of bulk, the filler material may be, for example, in a spherical shape, in a rectangular shape, in a pulverized form, or have different shapes which are a combination of these.

The content of the conductive fillers is preferably 5 to 100 wt. part for 100 wt. part of the entire solid content excluding the conductive filler, in the adhesive agent. The content of the conductive fillers exceeds 100 wt. part causes cohesion of the conductive fillers, thus leading to a rough adhesive layer surface. This deteriorates the adhesiveness and results in defective exterior appearances, and therefore is disadvantageous in terms of costs. The content of less than 5 wt. part on the other hand does not yield sufficient conductivity. Note that the above description reading "the entire solid content of the adhesive agent excluding the conductive filler" means the solid content which remains after excluding all the conductive filler contained in the adhesive agent, from the entire solid content in the adhesive agent structuring the adhesive layer.

The size of the conductive fillers is not particularly limited. For example, in cases where the fillers are in the form of bulk (in a spherical shape), a primary average particle size is preferably 0.1 to 1000 µm, and more preferably 1 to 100 µm. For example, the primary average particle size exceeding 1000 µm may cause defective exterior appearance.

Further, the first adhesive layer 13 may have a substrate. In such a case, the substrate needs to be conductive, and is preferably made of a metal material. The material of the substrate is not particularly limited as long as the material is conductive. Examples of the substrates include: copper, aluminum, nickel, silver, iron, and an alloy of any of these metals. Further, the substrate may be in the form of foil, mesh, or nonwoven fabric.

### (Second Adhesive Layer 14)

The second adhesive layer 14 of the present embodiment is an adhesive layer (double-faced adhesive sheet) for combining the metal layer 11 with the magnetic material layer 12. Note that, unlike the first adhesive layer 13, the second adhesive layer 14 is not a conductive adhesive agent. In other words, the second adhesive layer 14 is not a layer in which an additive or a filler for the purpose of improving the conductivity, or a layer having a structure for achieving conductivity, which structure is formed through a pattern formation.

The resin to be used for the second adhesive layer 14, though not particularly limited, may be a (meth) acrylic based, a natural rubber based, a synthesized rubber based, a silicone based, or a urethane based adhesive agent. The adhesive agent may adopt the identical material or may adopt different materials for different parts.

The additive or the like to be blended into the resin for the second adhesive layer 14 is not particularly limited. A dispersant, an age resister, an antioxidant, a processing material, a stabilizer, a defoamer, a flame retardant, a thickener, pigment, or the like, which is typically used as an agent to be blended in producing rubber or plastic may be added to an extent that does not spoil the effects of the present invention.

The second adhesive layer 14 is a double-faced adhesive sheet whose both side surfaces have adhesiveness; however, the second adhesive layer 14 may have a substrate (double-faced adhesive sheet with substrate). Alternatively, the second adhesive layer 14 may be a sheet only with adhesive layers, without any substrate (substrate less double-faced adhesive sheet). Further, the double-faced adhesive sheet may be in the form of sheet, tape, or the like. Further, in cases where the double-faced adhesive sheet has an adhesive layer on both sides of its substrate, it is possible to adopt different resin components for adhesive layers, respectively.

The material for the substrate is not particularly limited in cases of adopting, the double-faced adhesive sheet with a substrate as the second adhesive layer 14. Any of the following materials can be used as the adhesive sheet, singly or in combination with one another: a plastic film made of a polyolefin based resin such as polyethylene, polypropylene, ethylene-propylene, or the like, a polyester based resin such as polyethylene terephthalate, or the like, a resin material such as vinyl acetate based resin, polyimide based resin, a fluorine based resin, a polyvinyl chloride based resin, cellophane, or the like; a rubber sheet made of natural rubber, butyl rubber, or the like; a foam sheet made by foaming polyurethane, polychloroprene rubber, polyethylene, or the like; paper such as kraft paper, crepe tissue, Japanese paper, or the like; cloth such as cotton, spun rayon, or the like; nonwoven fabric such as cellulose based nonwoven fabric, polyester nonwoven fabric, vinylon nonwoven fabric, or the like; metal foil such as aluminum foil, copper foil; or the like.

Note that, for the both sides or on one side of the above substrate in the form of sheet, it is possible to conduct a surface treatment such as application of a primer, corona discharge treatment, or the like. The thickness of the substrate may be selected according to the needs; however in general, the thickness is preferably about 10 µm to 500 µm (typically 10µm to 200 µm). Note that the above substrate may be used alone, or in combination with two or more types of substrates. Further, the substrate may adopt a single layer structure or a multilayer structure.

The thickness of the second adhesive layer 14, though not particularly limited, is preferably 2 mm or less, and more preferably 1 mm or less. The second adhesive layer 14 however may adopt a single layer structure or a multilayer structure.

Note that a tackifying resin may be added to the above described first adhesive layer 13 and the second adhesive layer 14, to improve the adhesiveness. Such a tackifying resin may be, for example, a terpene based tackifying resin, a phenol based tackifying resin, a rosin based tackifying resin, a petroleum tackifying resin, or the like. These tackifying agents may be used singly or in combination.

Further, to control the gel fraction (ratio of insoluble matters in solvent) of the adhesive layer, a cross-linking agent is preferably added to the first adhesive layer 13 and the second adhesive layer 14. Examples of the cross-linking agent include: an isocyanate based cross-linking agent, an epoxy based cross-linking agent, a melamine based cross-linking agent, a peroxide based cross-linking agent, an urea based cross-linking agent, a metal alkoxide based cross-linking agent; a metal chelate based cross-linking agent, a metallic salt based cross-linking agent, a carbodiimide based cross-linking agent, an oxazoline based cross-linking agent, an aziridine based cross-linking agent, an amine based cross-linking agent, or the like. These cross-linking agents may be used singly or in combination with another.

### (Manufacturing Method of electromagnetic wave shielding sheet 1)

A manufacturing method typically adopted for manufacturing conventional multilayer materials may be adopted as the method for manufacturing the electromagnetic wave shielding sheet 1 of the present embodiment. For example, the first adhesive layer 13 serving as a conductive adhesive layer is formed on a detachable surface of a detachable sheet, and one of the surfaces of the metal layer 11 which is metal foil is pasted on the first adhesive layer 13. Apart from this, the second adhesive layer 14 which is an adhesive layer is formed on one side of the magnetic material layer 12 to prepare a magnetic sheet.

On the other surface of the metal layer 11, the side of second adhesive layer 14 on the magnetic sheet separately prepared is pasted and pressurized, thus forming the electromagnetic wave shielding sheet 1. Note that the method of stacking mesh layer of the electromagnetic wave shielding sheet 1 is not limited to this example.

Note that, to improve the conductivity, a multilayered structure with the metal layer 11 on one side and an adhesive agent such as the first adhesive layer 13 pasted on the other side may be subjected to the following process, with references to the methods described in the publications of Tokukaihei 8-185714, Tokukaihei 10-292155, Tokukaihei 11-302615.

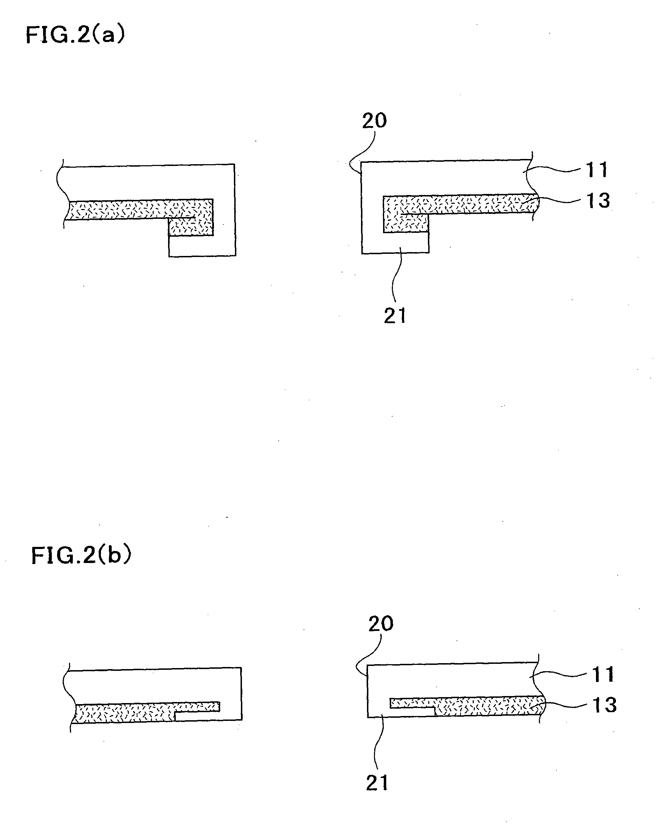

Fig. 2 is a schematic explanatory diagram showing the method of processing the metal layer 11 and the first adhesive layer 13. For the sake of easier understanding, Fig. 2 omits illustration of the magnetic material layer 12, the second adhesive layer 14, or the like.

First, a through hole 20 is pushed open from the other surface of the metal layer 11 (the surface opposite to the one on which the first adhesive layer 13 is pasted). The through hole 20 is pushed open to have a diameter larger than the thickness of the first adhesive layer 13. This way, in the position of the through hole 20 on the metal layer 11, there is formed an exposed part 21 which projects more than the first adhesive layer 13 (see Fig. 2 (a)).

By pressing the projecting exposed part 21 so as to flatten and spread the exposed part 21 outwardly in the directions of the diameter of the through hole 20, a cross section of the metal layer 11 is formed into a C-shape which sandwiches the first adhesive layer 13 (see Fig. 2 (b)). In other words, the metal layer 11 has an exposed part 21 which projects from a through hole 20 formed on the first adhesive layer 13, whose diameter is greater than the thickness of the first adhesive layer 13, and which is exposed on a surface of the first adhesive layer 13 opposite to the metal layer 11. This reliably enables the metal layer 11 and the first adhesive layer 13 to have a conductivity in the directions of the through hole, around the through hole 20.

### (Examples and Comparative Example)

Next, characteristics of magnetic shielding effects (electromagnetic shielding effects) of Examples 1 to 3 and Comparative Examples 1 to 3 are compared.

### [Experiment Conditions]

The electromagnetic shielding characteristics were evaluated by KEC method developed by KEC Electronic Industry Development Center. With the KEC method, the transmission loss was measured by using, as measurement devices, a shield box (MA8602B produced by Anritsu), a spectrum analyzer having a tracking generator (R3361A produced by Advance Test Corporation), and a preamplifier (MH648A produced by Anritsu). First, without placing a sample in the shield box, a state where all the electromagnetic waves permeates (through state) was set to 0 dB. Next, an aluminum plate of 250 mmx250 mmx2 mm in dimension was set in the shield box, and the electromagnetic shielding characteristic was measured. This shielding performance was set as the measurement limit. After that, measurement was conducted with sheets described in Examples of the present invention set in the shield box.

To measure the conductivity of the adhesive agent, a conductive adhesive agent was pasted on copper foil of 35 µm in thickness to use as a sample for evaluation. This sample was press pasted on an evaluation substrate so that the size of pasted portion was 5 mmx6 mm (30 mm²). The evaluation substrate was made by forming a pattern with silver on a glass epoxy plate. A constant current power source and an electrometer were set to this evaluation substrate, and the resistance value (Ω) at the time of supplying a current of 2A was measured.

### [Example 1]

The multilayer structure of an electromagnetic wave shielding sheet of Example 1 sequentially includes: a magnetic material layer, a second adhesive layer, a metal layer, and a first adhesive layer. In other words, the electromagnetic wave shielding sheet has a multilayer structure 10 shown in Fig. 1.

Specifically, the first adhesive layer of Example 1 was manufactured as follows. Through a usual method, acrylic acid 2-ethyl hexyl (30 wt. part), acrylic acid n-butyl (67 wt. part), and acrylic acid (3 wt. part) were subjected to solution polymerization (at 65°C for 5 hrs., 80°C for 2 hrs.), using toluene as a solvent, and azobisisobutyronitrile (0.1 wt. part) as the initiator, to produce an acrylic polymer solution (solid content concentration: 40.0 weight %) of approximately 500, 000 in weight-average molecular weight. To 100 wt. part of the solid content in the acrylic polymer solution, 35 wt. part of polymerized rosin pentaerythritol ester ("PENSEL D-125" supplied by Arakawa Chemical Industries) was blended as a tackifying resin to prepare a solution of an acrylic resin composition (solid content concentration: 46.8 weight %). To 100 wt. part of the solid content in this solution of the acrylic resin composition, 35 wt. part of silver powder ("Ag-HWQ-400" supplied by Fukuda Metal Foil & Powder Co., Ltd) as the conductive filler, 100 wt.part of toluene, and 2 wt. part of isocyanate cross-linking agent ("CORONATE L" manufactured by JAPAN POLYURETHANE INDUSTRY Co., Ltd) were blended and mixed for 10 minutes by a mixer, thus yielding a solution of a conductive adhesive agent (acrylic adhesive agent solution). The solution of the conductive adhesive agent thus obtained was applied on a detachable paper so that the thickness of the adhesive layer is 30 µm, thus preparing a conductive first adhesive layer. This first adhesive layer was pasted on copper foil of 35µm in thickness to measure the resistance value. The resulting resistance value was 0.03 Ω.

The metal layer of Example 1 was formed by stacking aluminum foil (produced by TOYO ALUMINIUM K.K.) of 80µm in thickness on the first adhesive layer. The magnetic material layer of Example 1 was formed by stacking a magnetic sheet ("FINEMET MS-F1 50-1M-T2" produced by Hitachi Metals, Ltd.; Thickness = 118µm) on this metal layer, with a use of double-faced adhesive tape of 10µm in thickness. In Example 1, the magnetic shielding effect was measured for the multilayer structure of 150 mm×100 mm in size, having four layers thus formed.

### [Example 2]

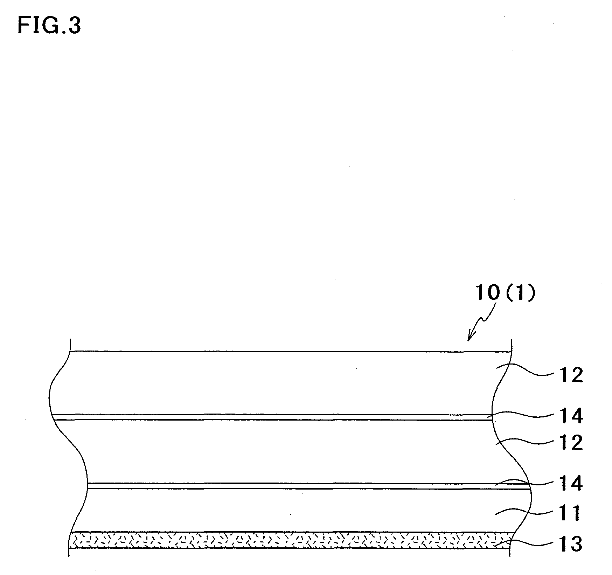

The multilayer structure of an electromagnetic wave shielding sheet of example 2 sequentially include: a magnetic material layer, a second adhesive layer, a magnetic material layer, a second adhesive layer, a metal layer, and a first adhesive layer. In short, the electromagnetic wave shielding sheet has a multilayer structure 10 as shown in Fig. 3.

In the present example, the magnetic shielding effect was evaluated in the same manner as Example 1, except in that another magnetic sheet ("FINEMET MS-F1 50-1M-T2" produced by Hitachi Metals, Ltd.; Thickness = 118µm) was further stacked on the magnetic layer using a double-faced adhesive tape of thickness 10 µm.

### [Example 3]

The multilayer structure of an electromagnetic wave shielding sheet of Example 1 sequentially include: a magnetic material layer, a second adhesive layer, a metal layer, and a first adhesive layer. In Example 3, however, the first adhesive layer was replaced with a non-conductive acrylic adhesive agent of 50µm in thickness. The magnetic shielding characteristic was evaluated as is done in Example 1, except for this difference.

### [Comparative Example 1]

A non-conductive acrylic adhesive agent was applied on a piece of detachable paper so its thickness is 50µm. On the adhesive agent is stacked a piece of aluminum foil (produced by TOYO ALUMINIUM K.K.) of 80µm in thickness. To this multilayer structure of 150 mm×100 mm in size, measurement of the magnetic shielding characteristic was conducted. This measurement was conducted only with the metal layer.

### [Comparative Example 2]

As a magnetic sheet was used FINEMET (MS-F1 50-1M-T2) which is a nano-crystal metal magnetic sheet produced by Hitachi Metals, Ltd. To this magnetic sheet of 150 mm×100 mm in size, measurement of the magnetic shielding characteristic was conducted. In short, the measurement was conducted only with the magnetic material layer.

### [Comparative Example 3]

Evaluation of the magnetic shielding characteristic was conducted as is done in Comparative Example 2, except in that two layers of magnetic sheets were stacked. In short, the measurement was conducted only with the magnetic material layer.

Table 1 shows results of magnetic shielding effects conducted at a frequency range of 0.1 MHz to 100 MHz, with respect to Examples 1 to 3 and Comparative Examples 1 to 3.

**[Table 1]**

| | MAGNETIC SHIELDING EFFECT / DB | | | | | | |
|---|---|---|---|---|---|---|---|
| MEASURED FREQUENCY / MHZ | MEASUREMENT LIMIT | EXAMPLE 1 | EXAMPLE 2 | EXAMPLE 3 | COMPARATIVE EXAMPLE 1 | COMPARATIVE EXAMPLE 2 | COMPARATIVE EXAMPLE 3 |
| 0.1 | 37.4 | 37.4 (MEASUREMENT LIMIT) | 37.4 (MEASUREMENT LIMIT) | 37.4 (MEASUREMENT LIMIT) | 15.6 | 33.3 | 37.2 |
| 0.2 | 49.7 | 49.7 (MEASUREMENT LIMIT) | 49.7 (MEASUREMENT LIMIT) | 49.7 (MEASUREMENT LIMIT) | 20.3 | 31.7 | 41.7 |
| 0.3 | 57.1 | 53.8 | 56.2 | 53.6 | 23.6 | 29.7 | 40.2 |
| 0.5 | 62.2 | 56.2 | 59.7 | 54.2 | 27.7 | 26.6 | 37.5 |
| 0.7 | 65.4 | 56.1 | 60.4 | 53.7 | 30.5 | 25.0 | 35.7 |
| 1 | 68.7 | 54.7 | 61.1 | 53.5 | 33.4 | 23.0 | 33.7 |
| 2 | 74.9 | 52.4 | 57.9 | 51.8 | 39.3 | 19.4 | 30.3 |
| 3 | 78.3 | 50.5 | 56.1 | 50.4 | 42.5 | 17.6 | 27.9 |
| 5 | 83.0 | 49.0 | 54.1 | 48.3 | 46.5 | 15.6 | 25.7 |
| 7 | 84.5 | 48.4 | 52.7 | 47.2 | 48.8 | 14.4 | 24.3 |
| 10 | 86.2 | 48.0 | 51.6 | 46.1 | 50.4 | 13.0 | 22.9 |
| 20 | 88.9 | 47.7 | 50.6 | 44.8 | 53.2 | 11.1 | 20.9 |
| 30 | 91.6 | 48.0 | 50.0 | 44.8 | 55.1 | 9.9 | 19.9 |
| 50 | 94.8 | 48.6 | 50.1 | 45.1 | 58.2 | 8.1 | 19.4 |
| 70 | 96.6 | 48.7 | 49.8 | 45.3 | 60.3 | 7.0 | 19.6 |
| 100 | 98.9 | 48.4 | 48.7 | 45.0 | 61.8 | 7.0 | 20.7 |

Referring to Table 1, it is found that Comparative Example 1 with only the characteristics of the metal layer has a physical property such that the magnetic shielding effect increases with an increase in the magnetic field intensity within the range of 0.1 MHz to 100 MHz. In other words, the magnetic shielding effect is low in the lower frequency area of this range.

Further, it is found that Comparative Examples 2 and 3 with only the characteristics of the magnetic material layer have a physical property such that the magnetic shielding effect increases with a decrease on the magnetic field intensity within the range of 0.1 MHz to 100 MHz. In other words, the magnetic shielding effect is low in the higher frequency area of this range.

Unlike these Comparative Examples, Examples 1 to 3 each including: at least one metal layer having a physical property such that its magnetic shielding effect increases with an increase in the magnetic field intensity within the range of 0.1 MHz to 100 MHz; and at least one magnetic material layer having a physical property such that its magnetic shielding effect increases with a decrease in the magnetic field intensity within the frequency range resulted in a less variation in the magnetic shielding effect even when the magnetic field intensity varies. As should be understood, the above examples are capable of maintaining stable shielding effect against the magnetic field intensities of a predetermined frequency range.

### (Modifications)

Thus, examples of the present invention are described hereinabove; however, it is obvious that the above examples solely serve as examples and are not to limit the present invention. The specific structures and the like of the present invention may be modified and designed according to the needs. Further, the actions and effects of the present invention described in the above embodiment are no more than most preferable actions and effects achieved by the present invention. The actions and effects of the present invention are not limited to those described in the above embodiment of the present invention.

For example, in cases where the first adhesive layer 13 is provided on one of the outermost layers of the electromagnetic wave shielding sheet, it is provide on the other outermost layer, at least one layer selected from a group including: an insulation layer having an insulation function; a protection layer having a protective function against damages caused by external environment; a design sheet layer having a design function. Alternatively, it is possible to provide a layer having a combination of the above functions.

The insulation layer is not particularly limited, and may be an insulation properties supporting medium (insulation film) made of a resin material such as: a thermoplastic resin such as a polyimide resin, polyamide resin, aramid resin, polyamide-imide resin, a phenoxy resin, an acrylic resin, a polycarbodiimide resin, a fluorine resin, a polyester resin, a polyurethane resin; polyester such as polyethylene terephthalate (PET), polyethylene naphthalate (PEN); polyolefin such as polypropylene; cellulose triacetate; or the like. The insulation layer may be directly formed on the outermost layer, or may be fixed by using an adhesive agent.

The protection layer is not particularly limited, and may be polyester such as polyethylene terephthalate (PET), polyethylene naphthalate (PEN); polyolefin such as polypropylene; a vinyl chloride resin; a fluorine resin; a polyurethane resin; an urethane acrylate resin; a silicone resin; a polystyrene resin. The resin may be used alone or may contain an additive or functional particles to achieve a certain function. The protection layer may be directly formed on the outermost layer, or may be formed into a film and then fixed by using an adhesive agent.

The design sheet layer is not particularly limited, and may be a film on which a design or a pattern is transferred or printed; or a film which is colored by a pigment or a dye. The design sheet layer may be directly formed on the outermost layer may be formed into a film and then fixed by using an adhesive agent.

### Reference Signs List

- 1: Electromagnetic wave shielding sheet
- 10: Multilayer Structure
- 11: Metal Layer
- 12: Magnetic Material Layer
- 13: First Adhesive Layer
- 14: Second Adhesive Layer
- 20: Through Hole
- 21: Exposed Part

## Claims

1. An electromagnetic wave shielding sheet for use in a wireless power transmitter, comprising a multilayer structure,
wherein the multilayer structure comprises
at least one metal layer; and
at least one magnetic material layer.

2. The electromagnetic wave shielding sheet according to claim 1, wherein
the multilayer structure has a first adhesive layer on at least one outermost layer.

3. The electromagnetic wave shielding sheet according to claim 2, wherein
the first adhesive layer has conductivity in a thickness direction.

4. The electromagnetic wave shielding sheet according to claim 1, wherein
the metal layer is made of metal foil, and
the magnetic material layer is formed in the form of sheet.

5. The electromagnetic wave shielding sheet according to any one of claims 1 to 3, wherein
the multilayer structure has a second adhesive layer having conductivity in a thickness direction, which combines the metal layer with the magnetic material layer.

6. The electromagnetic wave shielding sheet according to claim 2, wherein
the multilayer structure has
metal foil as the metal layer on one outermost layer, and the first adhesive layer on another outermost layer;
a through hole which is press opened from the metal foil towards the first adhesive layer, whose inner surface is the metal foil; and
an exposed part where the metal foil is exposed on the other outermost layer.

7. The electromagnetic wave shielding sheet according to any one of claims 1 to 4, wherein
the multilayer structure has
the first adhesive layer on one outermost layer; and
a layer having at least one of an insulating function, a damage protecting function, and a design function, on another outermost layer.
